# EUROPEAN PATENT APPLICATION

(11) **EP 2 602 353 A1**
(43) Date of publication of application: **12.06.2013**
(21) Application number: 12195405.1
(22) Date of filing: 04.12.2012
(51) Int. Cl.: C23C 14/04, C23C 16/02, C23C 16/27

(54) **Diamond film coated member and manufacturing method of the same**

(30) Priority: 05.12.2011 JP 2011266324
(71) Applicant: Keio University, Tokyo 108-8345 (JP); OSG Corporation, Toyokawa-shi, Aichi 442-0005 (JP)
(72) Inventor: Komotori, Jun, Yokohama-shi,, Kanagawa 223-8522 (JP); Sugiyama, Nobuhiko, Yokohama-shi,, Kanagawa 223-8522 (JP); Sakurai, Masatoshi, Toyokawa-shi,, Aichi 442-0005 (JP); Hanyu, Hiroyuki, Toyokawa-shi,, Aichi 442-0005 (JP); Murasawa, Koki, Toyokawa-shi,, Aichi 442-0005 (JP)
(74) Representative: TBK

(57) **Abstract**

It is an object to provide a diamond film coated member allowing a diamond film to be disposed relatively easily on a surface of base material with high adhesion strength, and a manufacturing method of the same.

Since the silicide layer 18 is rigidly disposed as the intermetallic compound layer on the surface of the tool base material 12 and the coating of the diamond film 16 is formed on the silicide layer 18, even if the tool base material 12 consists of steel material or cemented carbide containing an iron group element, the silicide layer 18 prevents the degeneration due to reaction between the iron group element in the tool base material 12 and diamond and the coating of the diamond film 16 can be achieved with high adhesiveness.

## Description

### TECHNICAL FIELD

The present invention relates to improvement in an abrasion-resistant member having a surface of a base material coated with diamond and particularly to a diamond film coated member excellent in adhesiveness and a manufacturing method thereof.

### BACKGROUND ART

A diamond film is commonly disposed on a surface of a member requiring abrasion resistance, such as a cutting tool main body. However, if it is attempted to dispose a diamond film on a surface of a member consisting of an iron group element such as high-speed tool steel, it is problematic that diamond and the iron group element react with each other to cause graphitization, resulting in degeneration.

In this regard, as described in Patent Document 1, after roughening a surface of a base material consisting of cemented carbide, a PVD method is used to dispose an intermediate layer consisting of solid solution of metal belonging to any one of the groups IVA, VA, and VIA exemplarily illustrated as TiAlN, CrAlN, and VAlN and aluminum nitride, and the intermediate layer is coated with a diamond film in a proposed technique. With this technique, even if the base material is cemented carbide containing a larger amount of Co, the intermediate layer disposed between the base material surface and the diamond film prevents the precipitation of Co and, therefore, the adhesiveness of the diamond film to the base material is acquired without performing removal treatment of Co using acid treatment.

### PRIOR ART DOCUMENT

### Patent Document

Patent Document 1: Japanese Laid-Open Patent Publication No. 2002-179493

### SUMMARY OF THE INVENTION

### Problem to Be Solved by the Invention

However, the conventional diamond film coated member as described above has a problem that sufficient attachment strength to the base material is not necessarily acquired from the diamond

The present invention was conceived in view of the situations and it is therefore an object of the present invention to provide a diamond film coated member allowing a diamond film to be disposed relatively easily on a surface of base material with high adhesion strength.

### Means for Solving the Problems

To achieve the object, a diamond film coated member of the present invention is comprised a base material including steel material or cemented carbide; an intermetallic compound layer formed on the surface of the base material by projecting projection particles containing a group IVB element while the base material is heated, the intermetallic compound layer made of the group IVB element contained in the projection particles and an iron group element contained in the base material or an element contained in the cemented carbide; and a diamond layer formed on the intermetallic compound layer.

A manufacturing method of the diamond film coated member is provided wherein projection particles containing a group IVB element are projected to a surface of heated base material including steel material or cemented carbide to form an intermetallic compound layer made of the group IVB element contained in the projection particles and an iron group element contained in the base material or an element contained in the cemented carbide on the surface of the base material and wherein a diamond layer is formed on the intermetallic compound layer.

### The Effects of the Invention

According to a diamond film coated member and a manufacturing method of the diamond film coated member in the present invention, an intermetallic compound layer is provided that made of the group IVB element contained in projection particles formed by projecting particles containing a group IVB element to a surface of heated base material including steel material or cemented carbide between the surface of the base material and a diamond layer, an iron group element contained in the base material or an element contained in the cemented carbide. Therefore, the intermetallic compound layer is rigidly fixed to the base material as the intermetallic compound and prevents the graphitization due to the reaction between the diamond layer formed on the intermetallic compound layer and the iron group element contained in the base material, thereby the stable diamond film having high adhesion strength can be acquired on the tool base material.

Preferably, the particles containing the group IVB element or an element of the group IVB are Si particles or particles containing Si. In this case, the silicide layer is rigidly formed on the surface of the base material as an intermetallic compound layer of the Si element contained in the projection particles and the iron group element contained in the base material or an element contained in cemented carbide, for example, Mo, Cr, and W. The silicide layer also prevents the graphitization due to the reaction between the diamond layer formed on the intermetallic compound layer and the iron group element contained in the base material. Since the silicide layer is diamond-bonded, a higher binding force to the diamond layer is achieved and the stable diamond film having higher adhesion strength can be acquired on the base material.

Preferably, the base material is steel material containing an iron group element Fe such as high-speed steel and tool steel. Since the intermetallic compound layer formed on the surface of the base material consisting of these steel materials or cemented carbide prevents the reaction between the iron group element contained in the base material and the diamond layer, the stable diamond film having high adhesion strength can be acquired on the base material.

The intermetallic compound layer has a film thickness of 10 µm to 100 µm. If the compound layer has a film thickness of 10 µm to 100 µm, the reaction between the iron group element contained in the base material or the element contained in cemented carbide and the diamond layer is certainly prevented regardless of unevenness and the stable diamond film having high adhesion strength can be acquired on the base material. If the film thickness of the intermetallic compound layer falls below 10 µm, it is difficult to certainly prevent the reaction between the iron group element contained in the base material and the diamond layer and if the film thickness exceeds 100 µm, the effect of increasing the bonding strength of the diamond film is saturated.

When the projection particles are projected, the base material is heated to a temperature of 850 to 1200 degrees C, preferably, 900 to 1100 degrees C and the projection particles are projected to the base material at an amount of 0.05 to 1.0 g/sec. If the base material temperature falls below 850 degrees C or an amount of the projection particles falls below 0.05 g/sec, the intermetallic compound layer formed on the base material becomes thinner and uneven and, therefore, the reaction between the iron group element contained in the base material and the diamond layer is not sufficiently prevented. If the base material temperature exceeds 1200 degrees C or an amount of the projection particles exceeds 1.0 g/sec, a uniform alloy layer is not formed because of the deformation of the base material and the unevenness of projection pressure and particles and, therefore, the effect of preventing the reaction between the iron group element contained in the base material and the diamond layer is not stabilized.

### BRIEF DESCRIPTION OF THE DRAWINGS

Fig. 1 is a diagram of an end mill that is an example of a diamond coated member of the present invention is applied and is a front view in a direction orthogonal to a shaft center.
Fig. 2 is a cross-sectional view in the vicinity of a surface of a cutting portion of the end mill of Fig. 1.
Fig. 3 is a diagram for explaining manufacturing steps of the end mill of Fig. 1.
Fig. 4 is a schematic diagram for explaining an example of a projecting apparatus used at a projection step of step S2 of Fig. 3.
Fig. 5 is a schematic diagram for explaining an example of a microwave plasma CVD apparatus used at a diamond film coating step of step S3 of Fig. 3.
Fig. 6 is a diagram of an electron microscope photograph enlarging the silicide layer acquired on the surface of the test piece in experimental example 1.
Fig. 7 is a diagram of analysis result acquired by using X-ray diffraction XRD performed for confirming a composition of the silicide layer acquired on the surface of the test piece in experimental example 1.
Fig. 8 is an electron microscope photograph enlarging the surface of the diamond film formed on the silicide layer of the surface of the test piece in experimental example 1.
Fig. 9 is a diagram of a result of Raman spectrometry performed for confirming the diamond bond of the diamond film formed on the silicide layer of the surface of the test piece in experimental example 1.
Fig. 10 is a diagram of an electron microscope photograph enlarging the silicide layer acquired on the surface of the test piece in experimental example 2.
Fig. 11 is an electron microscope photograph enlarging the surface of the diamond film formed on the silicide layer of the surface of the test piece in experimental example 2.
Fig. 12 is a diagram of the depths of the silicide layers acquired when test pieces different in composition were heated to different temperatures, the projection particles with different in composition were projected to the test pieces at different particle supply amounts, and an evaluation value for attachment strength of the diamond layers formed on the silicide layers in experimental example 3.

### MODES FOR CARRYING OUT THE INVENTION

A diamond coated member of the present invention is preferably applied to working tools such as a cutting tool requiring abrasion resistance, i.e., a diamond coated tool, and may also be applied to an object other than working tools if a base material is steel material or cemented carbide and a surface is coated with a diamond film. With regard to cutting tools, the diamond coated member is applicable to various working tools including rotary cutting tools such as end mill, tap, and drill, non-rotary cutting tools such as a tool bit, or rolling tools.

Cemented carbide making up the base material of the diamond coated member consists of, for example, a pseudo-binary alloy of carbide of a group IVA metal such as Ti and Zr, a group Va metal such as V and Nb, or a group VIa metal such as Cr and Mo, and a group VIII metal (iron group), has a structure with carbide crystals embedded in Co, such as the WC-Co system and the WC-Ti(Ta, Nb)C-Co system, and contains at least Co, which is an iron group element. The base material of the diamond coated member may be superfine particle cemented carbide containing a larger amount of Co.

An intermetallic compound layer is, for example, an intermetallic compound, i.e., metal silicide, formed on a base material surface by interdiffusion or alloying of Si contained in projection particles and an iron group element such as Fe, Co, Mo, Ti, Ni, and W contained in the base material consisting of steel material or cemented carbide. With regard to this intermetallic compound, when that metal is denoted by M, M₂Si is frequently created while MSi and MSi₂ are also commonly known, and M₃Si, M₂Si₃, MSi₃, etc., are further included. Specifically, the intermetallic compound layer is a silicide layer consisting of at least one of iron silicide Fe₃Si, cobalt silicide CoSi₂, molybdenum silicide Si₂Mo, titanium silicide TiSi₂, and tungsten silicide Si₂W, for example. The intermetallic compound layer acquired as described above may be a single layer or a multilayer.

For projection particles used in a projection step, a group IVB element, for example, Ge may be used in addition to Si or a mixture thereof may be used. Even in this case, the intermetallic compound is generated.

Before the projection step, a roughening step for roughening the base material surface is implemented as needed. For the roughening step, for example, the chemical corrosion such as electrolytic polishing and the sandblasting with abrasive grains of SiC etc., are preferably used.

For coating of the diamond film, a CVD method is preferably used and a microwave plasma CVD method and a hot filament CVD method are appropriate although other CVD methods such as a high-frequency plasma CVD method can also be used. The diamond film acquired as described above may be a single layer or a multilayer.

### Embodiments

Embodiments of the present invention will now be described in detail with reference to the drawings.

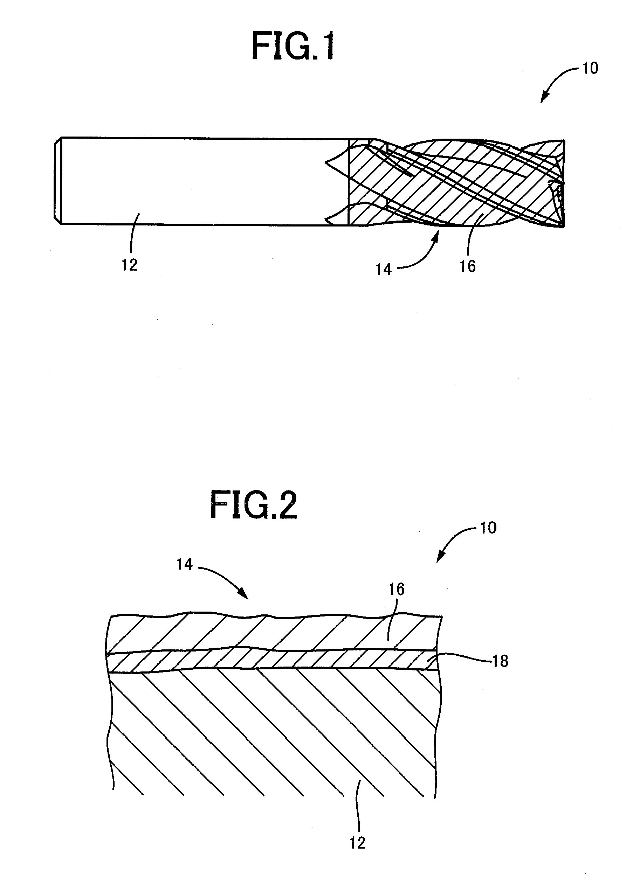

Fig. 1 is a diagram for explaining an end mill 10 that is an example of a hard film coated tool to which the present invention is applied and is a front view in a direction orthogonal to a shaft center. Fig. 2 is a cross-sectional view in the vicinity of a surface of a cutting portion 14 of the end mill 10 of Fig. 1. A tool base material (base material) 12 of the end mill 10 is made of superfine particle cemented carbide having an average particle diameter equal to or less than 1 µm in a hard phase consisting primarily ofWC and containing 5 to 10 wt% of Co, and the base material, i.e., the tool base material 12, is integrally disposed with a shank and the cutting portion 14. The cutting portion 14 is disposed with peripheral cutting edges and end cutting edges as cutting edges and the surface of the cutting portion 14 is coated with a diamond film 16 via a silicide layer 18. A shaded portion of Fig. 1 indicates the diamond film 16.

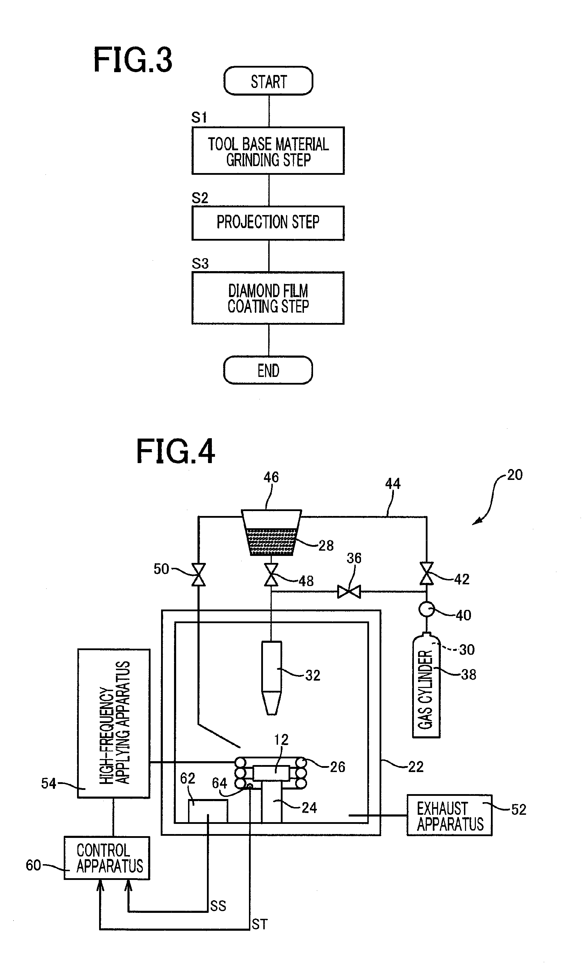

The end mill 10 is manufactured through steps depicted in Fig. 3. At step S1 corresponding to a tool base material grinding step, a grinding process etc., are performed for tool steel or cemented carbide to form the tool base material 12 having the peripheral cutting edges and the end cutting edges as the cutting edges. At step S2 corresponding to a projection step, a projecting apparatus 20 depicted in Fig. 4 is used for projecting projection particles 28 to the surface of the cutting portion 14 without performing removal treatment of Co using acid treatment etc., to form on the surface of the tool base material 12 the silicide layer 18 that is a compound layer consisting of an alloy (silicide, metal silicide) Si₂Co of Si contained in the projection particles 28 and Co contained in the tool base material 12, for example.

As depicted in Fig. 4, the projecting apparatus 20 includes an air-tightly configured chamber 22, a support pedestal 24 supporting the tool base material 12 that is an object to be processed in the chamber 22, an induction heating coil 26 disposed around the support pedestal 24 to heat the tool base material 12 supported by the support pedestal 24, and a particle injection nozzle 32 projecting or injecting the projection particles 28 and inert gas 30 toward the tool base material 12 supported by the support pedestal 24. The projecting apparatus 20 also functions as a surface processing apparatus causing the projection particles 28 to collide with the surface of the heated tool base material 12 and diffusing the element contained in the projection particles 28 to form an intermetallic compound layer or an alloy layer. The support pedestal 24 includes a mechanism rotating the tool base material 12 around the shaft center as needed so as to expose an area subjected to the diamond film coating in the surface of the tool base material 12 to the injected projection particles 28 projected from the particle injection nozzle 32.

The particle injection nozzle 32 in the chamber 22 is connected to a gas cylinder 38 and a flow-rating pressure control valve 40 supplying the inert gas 30 such as argon gas via an electromagnetic valve 36. The flow-rating pressure control valve 40 sets a flow rate or a pressure to achieve an injection velocity of several tens of meters to several thousand meters per second, for example. The flow-rating pressure control valve 40 is connected to a particle supply device 46 via an adjusting valve 42 and a gas supply tube 44. The particle supply device 46 is a container containing the projection particles 28, supplies the projection particles 28 through an adjusting valve 48 to the particle injection nozzle 32, and supplies the excess inert gas 30 for the supply of the projection particles 28 through an adjusting valve 50 into the chamber 22. The chamber 22 is connected to an exhaust apparatus 52 made up of an exhaust pump etc., exhausting gas in the chamber 22.

A high-frequency applying apparatus (a high-frequency induction heating apparatus) 54 connected to the induction heating coil 26 supplies high-frequency current at a single frequency or multiple frequencies to the induction heating coil 26. A control apparatus 60 is supplied with an oxygen concentration signal SS of an oxygen sensor 62 disposed in the chamber 22 to detect the oxygen concentration within the chamber 22 and a surface temperature signal ST from a temperature sensor 64 disposed on the support pedestal 24 to detect the surface temperature of the tool base material 12.

The control apparatus 60 is made up of a microcomputer, for example, and processes an input operation signal from an operator, the oxygen concentration signal SS, the surface temperature signal ST in accordance with a program stored in advance and controls the electromagnetic valve 36, the adjusting valve 42, the adjusting valve 48, the adjusting valve 50, the exhaust apparatus 52, and the high-frequency applying apparatus 54 so as to achieve preset operation of a heating temperature of the tool base material 12, an injection velocity and an injection amount of the projection particles 28, and an injection amount and an injection timing of the inert gas 30.

For example, the projection apparatus 20 configured as described above heats the tool base material 12 to a temperature of 850 to 1200 degrees C and projects the projection particles 28 to the surface of the tool base material 12 at a projection amount of 0.05 to 1.0 g/sec to form the silicide layer 18 that is a uniform intermetallic compound layer of Si and the iron group element in the tool base material 12 on the surface of the tool base material 12 with a thickness equal to or greater than 10 µm, preferably, a film thickness of 10 to 100 µm on the surface of the tool base material 12. If the tool base material 12 is steel material such as tool steel and high-speed steel, iron silicide Si₂Fe is formed. If the tool base material 12 is cemented carbide of, for example, the WC-Co system or the WC-Ti(Ta, Nb)C-Co system, at least one of cobalt silicide CoSi₂, titanium silicide TiSi₂, tungsten silicide Si₂W, etc., is formed.

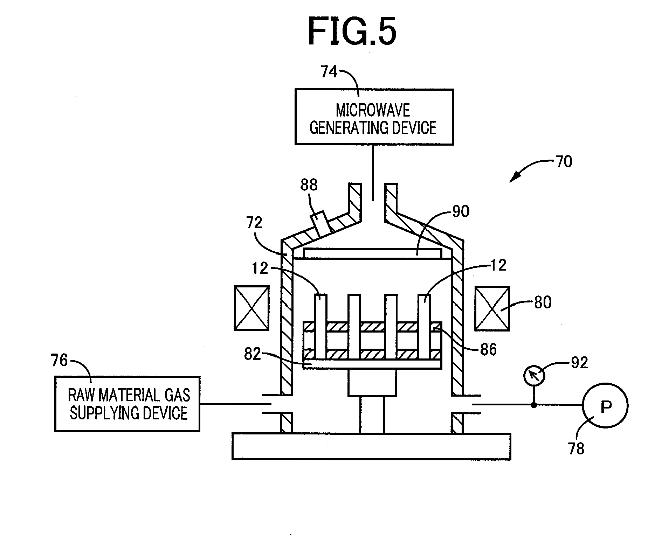

At a diamond film coating step S3 of Fig. 3, for example, a microwave plasma CVD apparatus 70 depicted in Fig. 5 is used for generating and growing diamond particles on the surface of the silicide layer 18 for coating with the diamond film 16. The diamond film 16 is formed with a film thickness, for example, on the order of 5 to 15 µm so as to acquire predetermined abrasion resistance and is disposed with high adhesiveness due to fine unevenness of the surface of the silicide layer 18.

The microwave plasma CVD apparatus 70 of Fig. 5 includes a reactor 72, a microwave generating device 74, a raw material gas supplying device 76, a vacuum pump 78, and an electromagnetic coil 80. A table 82 is disposed in the cylindrical reactor 72, and a plurality of the tool base materials 12 to be coated with the diamond films 16 is supported by a work support 86 and is disposed in an orientation with the cutting portions 14 facing upward. The microwave generating device 74 is a device generating microwave of 2.45 GHz, for example, and this microwave is introduced into the reactor 72 to heat the tool base materials 12 while the heating temperature is adjusted by power control of the microwave generating device 74. A radiation pyrometer is used through an observation window 88 for detecting the heating temperature (surface temperature) of the cutting portions 14 of the tool base materials 12 and feedback control is provided to the electric power of the microwave generating device 74 such that a predetermined heating temperature defined in advance is achieved. A quartz glass plate 90 is disposed in an upper portion in the reactor 72 for observing the appearance of the tool base materials 12 and retaining a vacuum state.

The raw material gas supplying device 76 is for the purpose of supplying raw material gases such as methane (CH₄), hydrogen (H₂), and carbon monoxide (CO) into the reactor 72 and includes a flow control valve, a flowmeter, etc., for controlling the gas flow rates thereof. The vacuum pump 78 is for the purpose of sucking the gas in the reactor 72 to reduce the pressure and the feedback control is provided to a motor current etc., of the vacuum pump 78 such that a pressure value within the reactor 72 detected by a pressure meter 92 matches a predetermined pressure value defined in advance. The electromagnetic coil 80 is disposed in an annular shape on the outer circumferential side of the reactor 72 so as to surround the reactor 72.

The coating process of the diamond film 16 consists of a nucleation stage and a crystal growth stage; in the nucleation stage, while the flow rates of methane and hydrogen are adjusted, the microwave generating device 74 is adjusted such that the surface temperature of the tool base material 12 and the silicide layer 18 is set to a setting temperature defined within a range of 700 to 900 degrees C; the vacuum pump 78 is operated such that the gas pressure in the reactor 72 is set to a setting pressure defined within a range of 2.7×10² Pa to 2.7×10³ Pa; and this state is continued for about 0.1 to 2 hours. As a result, a layer of nucleuses acting as origins of diamond crystal growth is attached to the surface of the silicide layer 18. In the crystal growth stage, for example, while the gas flow rates of methane and hydrogen are adjusted such that the concentration of methane is set to a setting value defined within a range of 1 % to 4 %, the microwave generating device 74 is adjusted such that the surface temperature of the silicide layer 18 is set to a setting temperature defined within a range of 800 to 900 degrees C; the vacuum pump 78 is operated such that the gas pressure in the reactor 72 is set to a setting pressure defined within a range of 1.3 ×10³ Pa to 6.7×10³ Pa; and this state is continued for a predetermined time to allow the crystal growth of diamond using the nucleuses as origins, thereby ensuring the diamond film 16 having a predetermined film thickness. By repeating the nucleation stage and the crystal growth stage, the microcrystal multilayer-structured diamond film 16 can be formed.

According to the end mill 10 manufactured as described above, since the silicide layer 18 is rigidly disposed as the intermetallic compound layer on the surface of the tool base material 12 and the coating of the diamond film 16 is formed on the silicide layer 18, even if the tool base material 12 consists of steel material or cemented carbide containing an iron group element, the silicide layer 18 prevents the degeneration due to reaction between the iron group element in the tool base material 12 and diamond and, therefore, the coating of the diamond film 16 can be achieved with high adhesiveness and high durability can be acquired. It is not necessary to perform removal treatment of Co and to dispose an intermediate layer consisting of solid solution of metal belonging to any one of the groups IVA, VA, and VIA exemplarily illustrated as TiAlN, CrAIN, and VAIN and aluminum nitride by using the PVD method after roughening the surface of the tool base material 12 as in the conventional case, and the end mill 10 can easily and inexpensively be manufactured.

Since the silicide layer 18 has high adhesiveness to the tool base material 12 and has the diamond bond, the diamond film 16 has high adhesion strength to the tool base material 12.

The projection particles 28 are particles containing the group IVB element or an element of the group IVB and are Si particles. In this case, the silicide layer 18 is rigidly formed on the surface of the tool base material 12 as an intermetallic compound layer of the Si element contained in the projection particles 28 and the iron group element contained in the tool base material 12 or an element contained in cemented carbide, for example, Mo, Cr, and W. The silicide layer 18 also prevents the graphitization due to the reaction between the diamond film 16 formed on the silicide layer 18 and the iron group element contained in the tool base material 12. Since the silicide layer 18 is diamond-bonded, a higher binding force to the diamond film 16 is achieved and the stable diamond film 16 having higher adhesion strength can be acquired on the tool base material 12.

The tool base material 12 is steel material containing the iron group element Fe, such as high-speed steel and tool steel, or cemented carbide. Since the silicide layer 18 formed on the surface of the tool base material 12 consisting of these steel materials or cemented carbide prevents the reaction between the iron group element contained in the tool base material 12 and the diamond film 16, the stable diamond film 16 having high adhesion strength can be acquired on the base material.

The silicide layer 18 has a film thickness of 10 µm to 100 µm. If the silicide layer 18 has a film thickness of 10 µm to 100 µm, the reaction between the iron group element contained in the tool base material 12 or the element contained in cemented carbide and the diamond film 16 is certainly prevented regardless of unevenness and the stable diamond film 16 having high adhesion strength can be acquired on the tool base material 12.

When the projection particles 28 are projected, since the tool base material 12 is heated to a temperature of 850 to 1200 degrees C, preferably, 900 to 1100 degrees C and the projection particles 28 are projected to the tool base material 12 at an amount of 0.05 to 1.0 g/sec, the uniform silicide layer 18 can be acquired.

Experimental examples 1 to 3 conducted to specifically clarify the effects of the present invention will hereinafter be described.

### <Experimental Example 1>

In the projecting apparatus (surface processing apparatus) 20 depicted in Fig. 4, a pellet-shaped test piece (15 mm ϕ×4 mm thick) made of the steel material S45C was heated to 1000 degrees C in the chamber 22 after replacement with the inert gas 30, and Si particles with the maximum particle diameter of 50 µm were projected to the test piece at a pressure of 0.4 MPa and an amount of 0.1 g/sec for 60 seconds to convert the surface of the test piece into silicide, forming a stable silicide layer having a thickness of 50 to 70 µm. The microwave plasma CVD apparatus 70 depicted in Fig. 5 was subsequently used to form a diamond film with a thickness of 12 µm on the silicide layer on the surface of the test piece.

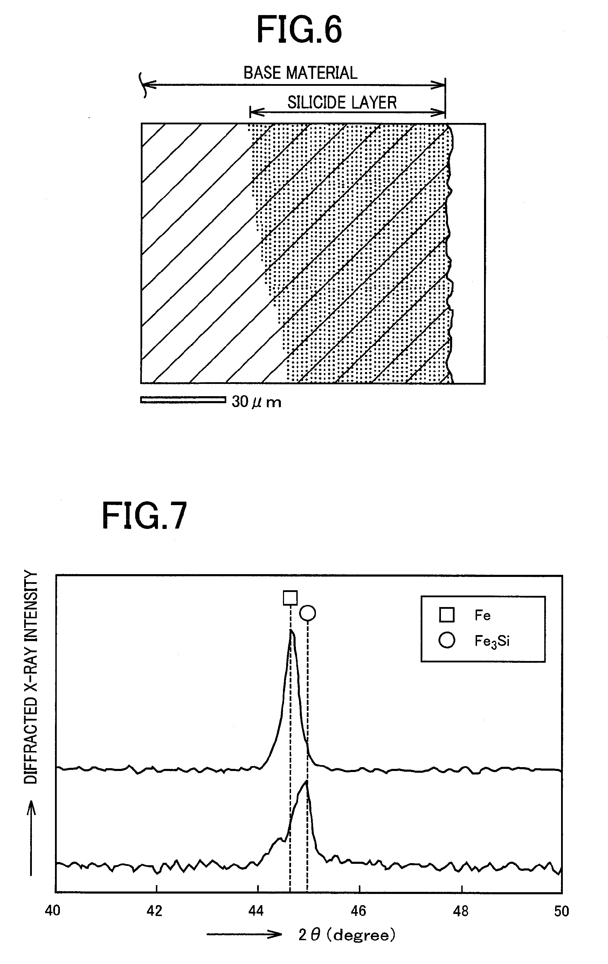

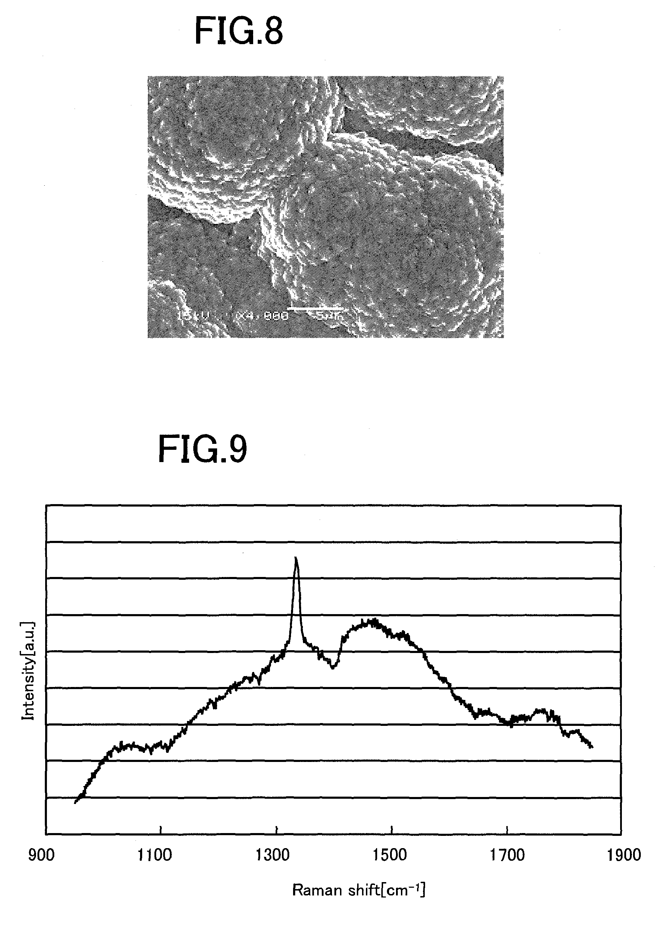

Fig. 6 is a diagram of an electron microscope photograph of a cross section of the surface of the test piece acquired by taking an enlarged image of the silicide layer and Fig. 7 is a diagram of a waveform acquired by analyzing the surface of the silicide layer by using X-ray diffraction XRD in comparison with a waveform of a test piece without a silicide layer. Fig. 8 is an electron microscope photograph of the enlarged diamond film on the surface of the test piece and Fig. 9 is a waveform indicative of a result of Raman spectrometry performed for confirming the formation of the diamond film on the surface of the test piece.

Fig. 6 is drawn because if the electron microscope photograph is directly depicted, color display is converted into shading, causing difficulty in identification. From Fig. 6, stable conversion into silicide was recognized to a depth of 62 to 76 µm from the surface of the test piece. In Fig. 7, as indicated in the lower waveform, a peak indicated by a circle was acquired at an angle indicative of iron silicide Fe₃Si. On the other hand, in the upper waveform of a test piece without a silicide layer, a peak indicated by a rectangle was acquired at an angle indicative of Fe. In Fig. 8, crystals of diamond are observed and the formation of the diamond film is confirmed. In the waveform from Raman spectrometry of Fig. 9, a peak is recognized at 1332 cm⁻¹ and it is confirmed that the diamond film having the diamond bond is formed on the silicide layer.

### <Experimental Example 2>

In the projecting apparatus (surface processing apparatus) 20 depicted in Fig. 4, a pellet-shaped test piece (15 mm ϕ×4 mm thick) made of the steel material S45C was heated to 1000 degrees C in the chamber 22 after replacement with the inert gas 30, and Si particles with the maximum particle diameter of 50 µm were projected to the test piece at a pressure of 0.4 MPa and an amount of 0.01 g/sec for 60 seconds to convert the surface of the test piece into silicide, forming a silicide layer of about 1/10 of the thickness. The microwave plasma CVD apparatus 70 depicted in Fig. 5 was subsequently used to form a diamond film with a thickness of 12 µm on the silicide layer on the surface of the test piece.

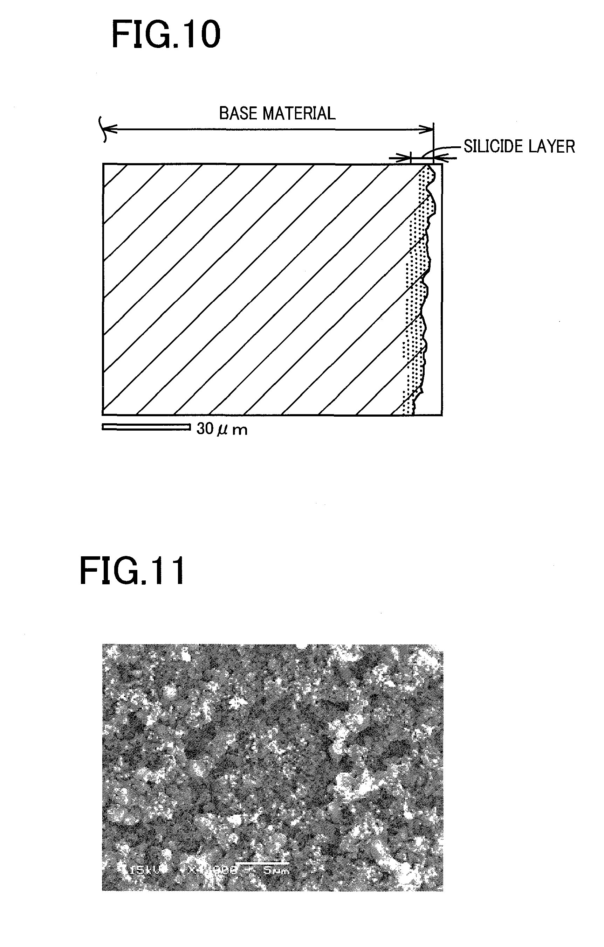

Fig. 10 is a diagram of an electron microscope photograph of a cross section of the surface of the test piece acquired by taking an enlarged image of the silicide layer and Fig. 11 is an electron microscope photograph enlarging the diamond film formed on the silicide layer. As depicted in Fig. 10, since the silicide layer formed on the surface of the test piece has a thickness on the order of 5 mm and is uneven, the diamond film depicted in Fig. 11 is reacted with the iron group element Fe in the test piece to be graphitized and is observed in a ragged state without rigid crystallization.

### <Experimental Example 3>

In the projecting apparatus (surface processing apparatus) 20 depicted in Fig. 4, while pellet-shaped test pieces (15 mm ϕ×4 mm thick) different in composition were heated to different heating temperatures in the chamber 22 after replacement with the inert gas 30, the projection particles 28 of different materials were projected at different particle supply amounts, and the microwave plasma CVD apparatus 70 depicted in Fig. 5 was subsequently used to form diamond films with a thickness of 12 µm on the silicide layers on the surfaces of the test pieces to create 14 types of test pieces. A thickness of the silicide layer before forming the diamond film was measured by using an enlarged cross section photograph and a film attachment force of the attached diamond film was evaluated for each test piece. With regard to the film attachment force, a time until occurrence of peeling was measured when SiC of #800 was used as projection medium and blasted at a pressure of 5 kg/cm², and a test piece was determined to be acceptable when the time exceeds 15 seconds.

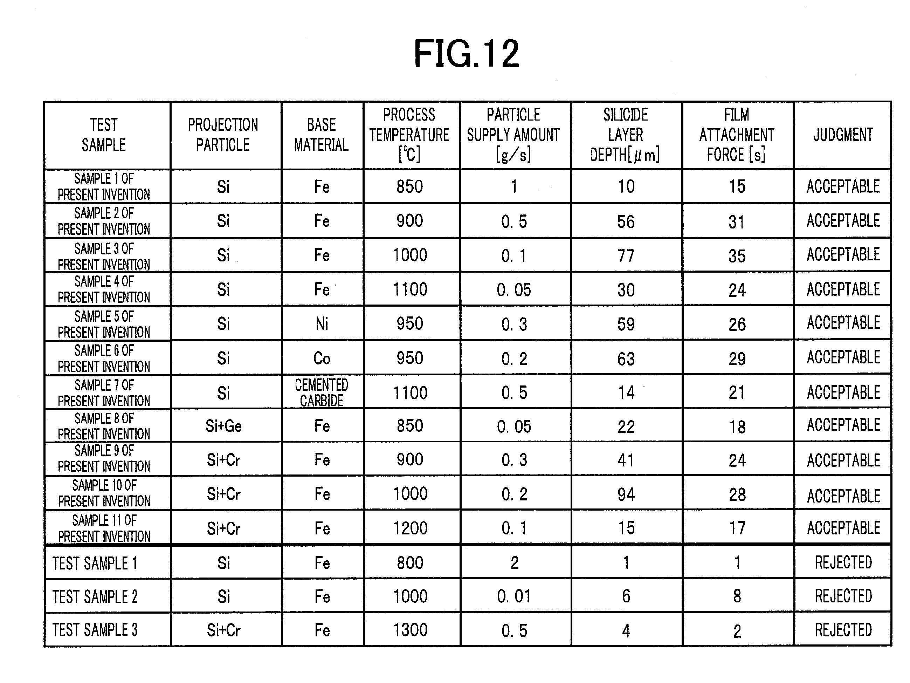

Fig. 12 depicts the silicide layer formation conditions, the depths (thicknesses) of the silicide layers, and the film attachment forces of the diamond films of the test pieces. As indicated by samples 1 to 11 of the present invention, when the material of the projection particles 28 is Si, Si+Ge, or Si+Cr and the test piece (base material) is Fe, Ni, Co, or cemented carbide, if the heating temperature is within a range of 850 to 1200 degrees C, preferably, 900 to 1100 degrees C and the supply amount of the projection particles 28 is within a range of 0.05 to 1.0 g/sec, the depth of the silicide layer of 10 to 94 µm was acquired along with the film attachment force of the diamond film exceeding 15 seconds. It is speculated that since the heating temperature of 800 degrees C is too low for a test sample 1; the supply amount of the projection particles 28 of 0.01 g/sec is too small for a test sample 2; and the heating temperature of 1300 degrees C is too high for a test sample 3, each of the test samples has the depth of the silicide layer lower than 10 µm and is rejected in terms of the film attachment force.

Although the embodiments of the present invention have been described in detail with reference to the drawings, the embodiments are merely exemplary embodiments and the present invention can be implemented in variously modified or altered forms based on the knowledge of those skilled in the art.

### Description of Reference Numerals

10: end mill (diamond coated member)
12: tool base material (base material)
16: diamond film
18: silicide layer (intermetallic compound layer)

It is an object to provide a diamond film coated member allowing a diamond film to be disposed relatively easily on a surface of base material with high adhesion strength, and a manufacturing method of the same.

Since the silicide layer 18 is rigidly disposed as the intermetallic compound layer on the surface of the tool base material 12 and the coating of the diamond film 16 is formed on the silicide layer 18, even if the tool base material 12 consists of steel material or cemented carbide containing an iron group element, the silicide layer 18 prevents the degeneration due to reaction between the iron group element in the tool base material 12 and diamond and the coating of the diamond film 16 can be achieved with high adhesiveness.

## Claims

1. A diamond film coated member (10) comprising:
a base material (12) including steel material or cemented carbide;
an intermetallic compound layer (18) formed on the surface of the base material by projecting projection particles containing a group IVB element while the base material is heated, the intermetallic compound layer made of the group IVB element contained in the projection particles and an iron group element contained in the base material or an element contained in the cemented carbide; and
a diamond layer formed on the intermetallic compound layer.

2. A manufacturing method of a diamond film coated member (10) wherein projection particles containing a group IVB element are projected to a surface of heated base material (12) including steel material or cemented carbide to form an intermetallic compound layer (18) made of the group IVB element contained in the projection particles and an iron group element contained in the base material or an element contained in the cemented carbide on the surface of the base material and wherein a diamond layer is formed on the intermetallic compound layer.

3. The manufacturing method of a diamond film coated member (10) of claim 2, wherein the particles containing the group IVB element or an element of the group IVB are Si particles or particles containing Si.

4. The manufacturing method of a diamond film coated member (10) of claim 2 or 3, wherein the base material (12) is steel material containing an iron group element Fe such as high-speed steel and tool steel.

5. The manufacturing method of a diamond film coated member (10) of any one of claims 2 to 4, wherein the intermetallic compound layer (18) has a film thickness of 10 µm to 100 µm.

6. The manufacturing method of a diamond film coated member (10) of any one of claims 2 to 5, wherein the base material (12) is heated at a temperature of 850 to 1200 degrees C, and wherein the projection particles are projected to the base material at a projection amount of 0.05 to 1.0 g/sec.
